# EUROPEAN PATENT APPLICATION

(11) **EP 4 509 855 A1**
(43) Date of publication of application: **19.02.2025**
(21) Application number: 22954303.8
(22) Date of filing: 09.08.2022
(51) Int. Cl.: G01R 31/54

(54) **INTERFACE CIRCUIT, ELECTRIC DEVICE, DETECTION METHOD, SYSTEM, MEDIUM, AND PROGRAM PRODUCT**

(71) Applicant: Contemporary Amperex Technology Co., Limited, Ningde, Fujian 352100 (CN)
(72) Inventor: JIAO, Hongzhe, Ningde, Fujian 352100 (CN); ZHAO, Kun, Ningde, Fujian 352100 (CN); ZHANG, Peiwei, Ningde, Fujian 352100 (CN); ZHOU, Kang, Ningde, Fujian 352100 (CN)
(74) Representative: Ran, Handong
(86) International application number: PCT/CN2022/111123
(87) International publication number: WO 2024/031324

(57) **Abstract**

The present application relates to an interface circuit, an electric device, a detection method, a system, a medium, and a program product. The charging device interface circuit comprises a charging interface and a voltage dividing circuit which are connected to each other, the voltage dividing circuit being connected to a power supply; the voltage dividing circuit is used for dividing the output voltage of the power supply and outputting a detection signal; when the charging interface is connected to and is not connected to a charging device, the voltage dividing circuit outputs different detection signals. The present application can be used to detect whether the charging device is connected to an electric device.

## Description

### TECHNICAL FIELD

The disclosure relates to the technology field of charging, and more particularly, relates to an interface circuit, an electric device, a detection method, a system, a media, and a program product.

### BACKGROUND

With the development of new energy technology, electric vehicles are becoming more and more popular, and the charging method of electric vehicles has become one of the main research directions.

Currently, an electric vehicle is charged through connection with a charging gun arranged on a charging pile. An Electric Vehicle Communication Controller (EVCC) usually detects whether the charging gun is connected to the vehicle according to duty cycle signals output by the charging pile in the charging process of the electric vehicle. However, in the case where an abnormal duty cycle signal is output or the duty cycle signal disappears, the EVCC cannot detect whether the charging gun is connected to the vehicle, and there may be a problem of pulling the charging gun when the vehicle starts to drive.

### SUMMARY

In view of the above problem, the disclosure discloses an interface circuit, an electric device, a detection method, a system, a media, and a program product, which may still detect whether the charging device is connected with the electric device even in case where an abnormal duty cycle signal is output or the duty cycle signal disappears.

A first aspect of the disclosure provides a charging device interface circuit, the charging device interface circuit includes a charging interface and a voltage divider circuit connected to each other, the voltage divider circuit is connected with a power supply; the voltage divider circuit is used for performing voltage division of an output voltage of the power supply and outputting a detection signal; the detection signal output by the voltage divider circuit in case where the charging interface is connected to a charging device is different from the detection signal output by the voltage divider circuit in case where the charging interface is not connected to a charging device.

In the technical solutions of the embodiments of the disclosure, it is the charging device interface circuit that detects whether the charging device is connected, which will not be affected by the duty cycle signals output by the charging pile, even in case where an abnormal duty cycle signal is output or the duty cycle signal disappears. In this way, the problem of pulling the charging device when the electric device starts to drive may be avoided.

In some embodiments, the voltage divider circuit includes a first voltage divider circuit and a second voltage divider circuit; the first voltage divider circuit and the second voltage divider circuit are connected in series, a common terminal of the first voltage divider circuit and the second voltage divider circuit is electrically connected with the charging interface, the second voltage divider circuit is also connected with the power supply; and the first voltage divider circuit is used for outputting the detection signal. In the technical solutions of the embodiments of the disclosure, since the detection signal is realized based on the circuit structure, it is not affected by the duty cycle signals output by the charging pile, and it is also possible to detect whether the charging device is connected to the electric device even in case where an abnormal duty cycle signal is output or the duty cycle signal disappears.

In some embodiments, the first voltage divider circuit includes a first resistor, a second resistor and a third resistor; a first terminal of the first resistor is connected to the second voltage divider circuit, a second terminal of the first resistor is grounded; a first terminal of the second resistor is connected to the first terminal of the first resistor, a second terminal of the second resistor is connected to a first terminal of the third resistor; and a second terminal of the third resistor is grounded. In the technical solutions of the embodiments of the disclosure, two different equivalent resistors are formed in the two cases where the charging device is connected and where the charging device is not connected, thus affecting the voltage division performed by the first voltage divider circuit and the second voltage divider circuit. Because the detection signals are output through hardware connection, the detection signals are not affected by the duty cycle signals, and it is possible to accurately detect whether the charging device is connected to the electric device.

In some embodiments, the first voltage divider circuit further includes a fourth resistor and a capacitor; and a first terminal of the fourth resistor is connected to the second terminal of the second resistor, a second terminal of the fourth resistor is connected to a first terminal of the capacitor, and a second terminal of the capacitor is grounded. In the technical solutions of the embodiments of the disclosure, the detection signal is defined through the fourth resistor, and by filtering out the interference signal in the detection signal with the capacitor, subsequent identification of the detection signal is made more convenient.

In some embodiments, the second voltage divider circuit includes a fifth resistor; a first terminal of the fifth resistor is connected to the power supply, and a second terminal of the fifth resistor is connected to the first voltage divider circuit. In the technical solutions of the embodiments of the disclosure, because the voltage divider circuit outputs the detection signals through hardware connection, the detection signals are not affected by the duty cycle signals, and it is possible to accurately detect whether the charging device is connected with the electric device.

A second aspect of the disclosure provides an electric device, the electric device includes the charging device interface circuit according to the first aspect.

In the technical solutions of the embodiments of the disclosure, since the charging device interface circuit detects whether the electric device is connected to the charging device through hardware connection, this may not be affected by the duty cycle signals output by the charging pile, and it is still possible to detect whether the charging device is connected to the electric device even in case where an abnormal duty cycle signal is output or the duty cycle signal disappears, thus avoiding the problem of pulling the charging device when the electric device starts to drive.

A third aspect of the disclosure provides a charging detection method applicable to a charging device interface circuit including a charging interface and a voltage divider circuit connected to each other, the method includes: obtaining a detection signal from the voltage divider circuit; and determining, in case where a parameter value of the detection signal is in a preset parameter value range, that the charging interface is connected to a charging device.

In the technical solutions of the embodiments of the disclosure, the charging device interface circuit outputs the detection signal through hardware connection, and detects whether the electric device is connected to the charging device according to the detection signal. It is possible to accurately detect whether the charging device is connected to the electric device.

In some embodiments, the method further includes: determining, in case where the parameter value is not in the preset parameter value range, that the charging interface is connected to the charging device. In the technical solutions of the embodiments of the disclosure, the charging device interface circuit outputs the detection signal through hardware connection, and detects whether the electric device is connected to the charging device according to the detection signal. It is possible to accurately detect whether the charging device is connected to the electric device.

In some embodiments, the method further includes: sending, in case where it is determined that the charging interface is connected to the charging device, a first connection message to a device controller of the electric device; the first connection message is used to instruct the controller to prohibit the electric device from traveling. In the technical solutions of the embodiments of the disclosure, by using the device controller to prohibit the electric device from travelling, the problem of pulling the charging device may be avoided in case where a user starts the electric device but forgets to disconnect the electric device and the charging device after charging.

In some embodiments, the method further includes: sending, in case where it is determined that the charging interface is connected to the charging device, a second connection message to a display of the electric device; the second connection message is used to instruct the display to display that the electric device is connected to the charging device. In the technical solutions of the embodiments of the disclosure, it is possible to remind the driver that the electric device is connected to the charging device through the display, so as to avoid the problem of pulling the charging device in case where a user starts the electric device but forgets to disconnect the electric device and the charging device.

In some embodiments, the method further includes: determining a resistance of the charging device according to the detection signal; determining a target current corresponding to the resistance of the charging device according to preset mapping between resistance and current values; and sending a charging request to an on-board charger of the electric device; wherein the target current is included in the charging request, for instructing the on-board charger to charge a battery of the electric device according to the target current. In the technical solutions of the embodiments of the disclosure, the target current corresponding to the resistance of the charging device is determined, so that the on-board charger may perform current conversion according to the target current, so as to use the appropriate DC current to charge the battery of the electric device, which ensures the charging safety of the electric device.

In some embodiments, the method further includes: obtaining a wake-up signal; the wake-up signal includes a wake-up signal sent by a communication controller of the electric device after detecting a duty cycle signal output by a charging pile, and a wake-up signal output by the electric device after charging of the battery is completed; and performing a waking-up operation according to the wake-up signal, and obtaining the detection signal output by the charging device interface circuit. In the technical solutions of the embodiments of the disclosure, by using the wake-up signal to wake up the battery management system, it may be ensured that the battery management system can timely and accurately detect whether the electric device is connected to the charging device, so as to avoid the problem of pulling the charging device when the electric device starts to drive.

A fourth aspect of the disclosure provides a charging detection system, the charging detection system includes a battery management system and the charging device interface circuit according to the first aspect; the charging device interface circuit is used for outputting the detection signal; the battery management system is used for obtaining the detection signal and determining whether the electric device is connected to the charging device according to a parameter value of the detection signal and a preset parameter value range.

In the technical solutions of the embodiments of the disclosure, since the charging device interface circuit outputs the detection signal through hardware connection, the battery management system may detect whether the charging device is connected to the electric device without being affected by the duty cycle signal output by the charging pile, so as to avoid the problem of pulling the charging device when the electric device starts to drive.

In some embodiments, the charging detection system further includes a device controller; the battery management system sends a first connection message to the device controller in case where it is determined that the electric device is connected to the charging device; and the controller is used for prohibiting the electric device from travelling according to the first connection message. In the technical solutions of the embodiments of the disclosure, even if the user starts to drive because he/she forgets that the electric device is connected to the charging device, the electric device will stay in place because the device controller prohibits the electric device from travelling, so the problem of pulling the charging device may be avoided.

In some embodiments, the charging detection system further includes a display; the battery management system is also used for sending a second connection message to the display in case where it is determined that the electric device is connected to the charging device; and the display is used for displaying that the electric device is connected to the charging pile according to the second connection message. In the technical solutions of the embodiments of the disclosure, it is possible to remind the user that the electric device is connected to the charging device through the display, so as to avoid the problem of pulling the charging device in case where the user starts the electric device but forgets that the electric device is connected to the charging device.

In some embodiments, the charging detection system further includes an on-board charger; the battery management system is also used for determining a resistance of the charging device according to the detection signal, and determining a target current corresponding to the resistance of the charging device according to preset mapping between resistance and current values and the resistance of the charging device, and sending a charging request to the on-board charger; the target current is included in the charging request; and the on-board charger is used for charging a battery of the electric device according to the target current. In the technical solutions of the embodiments of the disclosure, the on-board charger may perform current conversion, so as to use the appropriate current to charge the battery of the electric device, which ensures the charging safety of the electric device.

In some embodiments, the charging detection system further includes a communication controller; the communication controller is used for sending a wake-up signal to the battery management system after detecting a duty cycle signal output by a charging pile; and the battery management system is used for obtaining the wake-up signal, performing a waking-up operation according to the wake-up signal, and obtaining the detection signal output by the charging device interface circuit. In the technical solutions of the embodiments of the disclosure, by waking up the battery management system, the battery management system may be allowed to timely and accurately detect whether the electric device is connected to the charging device, so as to avoid the problem of pulling the charging device when the electric device starts to drive.

A fifth aspect of the disclosure provides a computer-readable storage medium storing thereon a computer program, which, when executed by a processor, implements steps of the method according to the third aspect.

A sixth aspect of the disclosure provides a computer program product including a computer program, which, when executed by a processor, implements steps of the method according to the third aspect.

### BRIEF DESCRIPTION OF THE DRAWINGS

By reading the detailed description of the alternative embodiments below, various other advantages and benefits will become apparent to those skilled in the art. The accompanying drawings are intended only to illustrate the purpose of the alternative embodiments and are not considered to be a limitation of the disclosure. Moreover, same parts are represented by same reference numbers throughout the drawings. In the accompanying drawings:
FIG. 1 is a first schematic structure diagram of a charging device interface circuit in one embodiment of the disclosure;
FIG. 2 is a second schematic structure diagram of a charging device interface circuit in one embodiment of the disclosure;
FIG. 3 is third schematic structure diagram of a charging device interface circuit in one embodiment of the disclosure;
FIG. 4 is fourth schematic structure diagram of a charging device interface circuit in one embodiment of the disclosure;
FIG. 5 is fifth schematic structure diagram of a charging device interface circuit in one embodiment of the disclosure;
FIG. 6 is a first schematic flow chart of a charging detection method in one embodiment of the disclosure;
FIG. 7 is a second schematic flow chart of a charging detection method in one embodiment of the disclosure;
FIG. 8 is a third schematic flow chart of a charging detection method in one embodiment of the disclosure;
FIG. 9 is a first schematic structure diagram of a charging detection system in one embodiment of the disclosure;
FIG. 10 is a second schematic structure diagram of a charging detection system in one embodiment of the disclosure;
FIG. 11 is a third schematic structure diagram of a charging detection system in one embodiment of the disclosure;
FIG. 12 is a fourth schematic structure diagram of a charging detection system in one embodiment of the disclosure;
FIG. 13 is a fifth schematic structure diagram of a charging detection system in one embodiment of the disclosure.

The reference numbers are as follows:
charging device interface circuit 10, charging interface 11, voltage divider circuit 12, first voltage divider circuit 121;
second voltage divider circuit 122, first resistor R1, second resistor R2, third resistor R3;
fourth resistor R4, capacitor C, fifth resistor R5;
battery management system 20, device controller 30, display 40, on-board charger 50;
communication controller 60.

### DETAILED DESCRIPTION OF THE EMBODIMENTS

The embodiments of the technical solutions of the disclosure will be described in detail in combination with the accompanying drawings below. The following embodiments are intended only to more clearly describe the technical solutions of the disclosure and are therefore used as examples only, and cannot be used to limit the protection scope of the disclosure.

Unless otherwise defined, all technical and scientific terms used herein have the same meanings as those generally understood by those skilled in the art of the disclosure. The terms used herein are for the purpose of describing specific embodiments only and are not intended to limit the disclosure. The terms "including" and "having" and any variations thereof in the specification and claims of the disclosure and in the description of the drawings above are intended to cover non-exclusive inclusion.

In the description of the embodiments of the disclosure, the technical terms "first", "second", etc., are used only to distinguish between different objects and are not to be construed as indicating or implying relative importance or as implicitly indicating the quantity, particular order or priority of the indicated technical features. In the description of the embodiments of the disclosure, "multiple" means more than two, unless otherwise expressly specified.

The referred "embodiment" herein means that a particular feature, structure or characteristic described in conjunction with an embodiment may be included in at least one embodiment of the disclosure. The presence of the word at various locations in the specification does not necessarily refer to the same embodiment, nor is it a separate or alternative embodiment that is mutually exclusive with other embodiments. It is understood, both explicitly and implicitly, by those skilled in the art that embodiments described herein may be combined with other embodiments.

In the description of the embodiments of the disclosure, the term "and/or" is merely an association relationship describing associated objects, indicating that there may be three relationships. For example, A and/or B may indicate three situations: A exists alone, A and B exist simultaneously, and B exists alone. In addition, the character "/" herein generally indicates that the associated objects are in an "or" relationship.

In the description of the embodiments of the disclosure, the term "multiple" refers to more than two (including two). Similarly, "multiple groups" refers to more than two (including two) groups, and "multiple pieces" refers to more than two (including two) pieces.

In the description of the embodiments of the disclosure, unless otherwise expressly specified and defined, the technical terms "installation", "interconnection", "connection", "fixation" and other terms shall be understood in a broad sense. For example, it may be a fixed connection, may be a detachable connection, or may be an integration. It may be a mechanical connection or an electrical connection. It may be a direct connection, and it may also be an indirect connection through an intermediate medium. It may be a communication within two components or an interaction between two components. For those skilled in the art, the specific meaning of the above terms in the embodiments of the disclosure may be understood on a case-by-case basis.

Currently, an electric vehicle is charged through connection with a charging gun arranged on a charging pile. An EVCC in the electric vehicle usually detects whether the charging gun is connected to the vehicle according to duty cycle signals output by the charging pile in the charging process of the electric vehicle. That is, the EVCC determines that the charging gun is connected to the vehicle when detecting a duty cycle signal; and the EVCC determines that the charging gun is not connected to the vehicle when detecting no duty cycle signal. However, in the case where an abnormal duty cycle signal is output or the duty cycle signal disappears, the EVCC cannot detect whether the charging gun is connected to the vehicle, and there may be a problem of pulling the charging gun when the vehicle starts to drive.

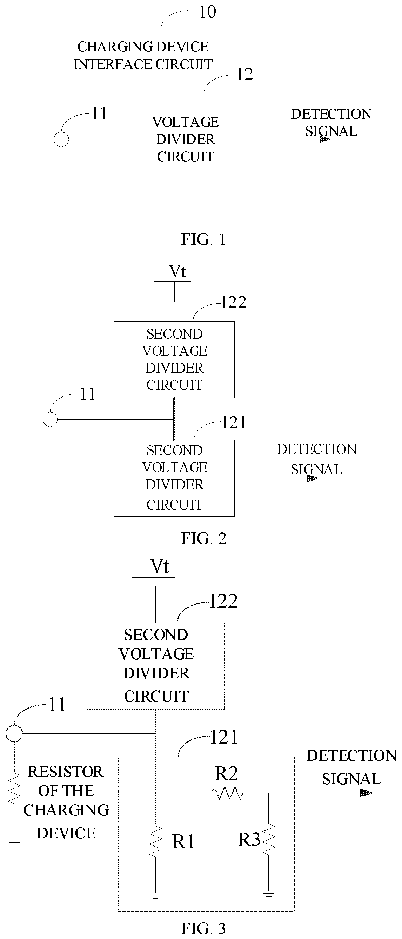

Referring to FIG. 1, a charging device interface circuit 10 is provided according to some embodiments of the disclosure. The charging device interface circuit 10 includes a charging interface 11 and a voltage divider circuit 12 connected to each other. The voltage divider circuit 12 is connected with the power supply Vt. The voltage divider circuit 12 is used for performing voltage division of the output voltage of the power supply Vt and outputting a detection signal. The voltage divider circuit 12 outputs different detection signals in cases where the charging interface 11 is connected to a charging device and where the charging interface 11 is not connected to a charging device.

In the embodiments of the disclosure, the charging device interface circuit 10 includes the charging interface 11 and the voltage divider circuit 12. In this case, the voltage divider circuit 12 is respectively connected with the charging interface 11 and the power supply Vt. The voltage divider circuit 12 may perform voltage division of the output voltage of the power supply Vt and output the detection signal.

In case where the charging interface 11 is connected to the charging device, the voltage divider circuit 12 performs the voltage division according to the charging device and its own circuit structure, and outputs a first detection signal. In case where the charging interface 11 is not connected to the charging device, the voltage divider circuit 12 performs the voltage division according to its own circuit structure, and outputs a second detection signal. It is understood that the detection signals output by the voltage divider circuit 12 are different because whether the charging interface 11 is connected to the charging device or not will change the voltage division performed by the voltage divider circuit 12. In addition, in case where the charging device connected by the charging device interface circuit 10 is of a different type, the voltage division performed by the voltage divider circuit 12 will change, and the detection signal output of the voltage divider circuit 12 is also different. The embodiments of the disclosure do not impose any limitation on the type of the charging device.

The above charging device interface circuit includes a charging interface and a voltage divider circuit connected with each other, where the voltage divider circuit is connected with a power supply, the voltage divider circuit is used for voltage division of the output voltage of the power supply and outputting a detection signal. The voltage divider circuit outputs different detection signals in cases where the charging interface is connected to a charging device and where the charging interface is not connected to a charging device. In the embodiments of the disclosure, since the structure of the charging device interface circuit is unchanged, and whether the charging device is connected or not will change the voltage division performed by the voltage divider circuit, it is possible to detect whether the charging device is connected to the electric device by using the charging device interface circuit to detect whether the charging device is connected, which will not be affected by the duty cycle signals output by the charging pile, even in case where an abnormal duty cycle signal is output or the duty cycle signal disappears. In this way, the problem of pulling the charging device when the electric device starts to drive may be avoided.

Referring to FIG. 2, according to some embodiments of the disclosure, the voltage divider circuit 12 includes a first voltage divider circuit 121 and a second voltage divider circuit 122. The first voltage divider circuit 121 and the second voltage divider circuit 122 are connected in series, a common terminal of the first voltage divider circuit 121 and the second voltage divider circuit 122 is electrically connected with the charging interface 11, and the second voltage divider circuit 122 is also connected with the power supply Vt. The first voltage divider circuit 121 is used for outputting a detection signal.

In the embodiments of the disclosure, the voltage divider circuit 12 includes a first voltage divider circuit 121 and a second voltage divider circuit 122, and the second voltage divider circuit 122 is also connected to a power supply Vt. Since the first voltage divider circuit 121 and the second voltage divider circuit 122 are connected in series, the first voltage divider circuit 121 and the second voltage divider circuit 122 may perform voltage division of the output voltage of the power supply Vt, and the first voltage divider circuit 121 may output the detection signals according to the voltage division.

The common terminal of the first voltage divider circuit 121 and the second voltage divider circuit 122 is connected with the charging interface 11. In case where the charging interface 11 is connected to the charging device, the first voltage divider circuit 121 and the second voltage divider circuit 122 perform voltage division of the output voltage of the power supply Vt according to the charging device and the circuit structures of the first voltage divider circuit 121 and the second voltage divider circuit 122, and the first voltage divider circuit 121 outputs the first detection signal.

In case where the charging interface 11 is not connected to the charging device, the first voltage divider circuit 121 and the second voltage divider circuit 122 perform voltage division of the output voltage of the power supply Vt according to the circuit structures of the first voltage divider circuit 121 and the second voltage divider circuit 122, and the first voltage divider circuit 121 outputs the second detection signal.

In the above embodiments, the voltage divider circuit includes the first voltage divider circuit and the second voltage divider circuit, the first voltage divider circuit and the second voltage divider circuit are connected in series, the common terminal of the first voltage divider circuit and the second voltage divider circuit is electrically connected with the charging interface, and the second voltage divider circuit is also connected with the power supply. The first voltage divider circuit outputs the detection signals. In the embodiments of the disclosure, the first voltage divider circuit and the second voltage divider circuit perform different voltage divisions in two cases where the charging device is connected and where the charging device is not connected, and different detection signals are output. Since the detection signal is realized based on the circuit structure, it is not affected by the duty cycle signals output by the charging pile, and it is also possible to detect whether the charging device is connected to the electric device even if an abnormal duty cycle signal is output or the duty cycle signal disappears.

Referring to FIG. 3, according to some embodiments of the disclosure, the first voltage divider circuit 121 includes a first resistor R1, a second resistor R2 and a third resistor R3. A first terminal of the first resistor R1 is connected to the second voltage divider circuit 122, a second terminal of the first resistor R1 is grounded, a first terminal of the second resistor R2 is connected to the first terminal of the first resistor R1, a second terminal of the second resistor R2 is connected to a first terminal of the third resistor R3, and a second terminal of the third resistor R3 is grounded.

In the embodiments of the disclosure, the first voltage divider circuit 121 includes the first resistor R1, the second resistor R2, and the third resistor R3. In this case, the first terminal of the first resistor R1 is connected to the second voltage divider circuit 122, the second terminal of the first resistor R1 is grounded, the first terminal of the second resistor R2 is connected to the first terminal of the first resistor R1, that is, the first terminal of the second resistor R2 is also connected to the second voltage divider circuit 122, the second terminal of the second resistor R2 is connected to the first terminal of the third resistor R3, and the second terminal of the third resistor R3 is grounded.

As shown in FIG. 3, the second resistor R2 and the third resistor R3 are connected in series to form a first equivalent resistor. In case where the charging interface 11 is connected to the charging device, the first equivalent resistor, the first resistor R1, and a resistor of the charging device are connected in parallel to form a second equivalent resistor. The second equivalent resistor and the second voltage divider circuit 122 are connected in series to perform voltage division of the output voltage of the power supply Vt, and output the first detection signal from the common terminal of the second resistor R2 and the third resistor R3.

In case where the charging interface 11 is not connected to the charging device, the first equivalent resistor and the first resistor R1 are connected in parallel to form the third equivalent resistor. The third equivalent resistor and the second voltage divider circuit 122 are connected in series to perform voltage division of the output voltage of the power supply Vt, and output the second detection signal from the common terminal of the second resistor R2 and the third resistor R3.

It should be understood that in the two cases where the charging interface 11 is connected to the charging device and where the charging interface 11 is not connected to the charging device, the first voltage divider circuit 121 forms the second equivalent resistor and the third equivalent resistor respectively. Due to the different resistances of the second equivalent resistor and the third equivalent resistor, the first voltage divider circuit 121 and the second voltage divider circuit 122 perform voltage division of the output voltage of the power supply Vt to obtain different detection signals.

Optionally, the resistance of the first resistor R1 may be 100 kΩ, and the resistances of the second resistor R2 and the third resistor R3 may be 47 kΩ. The resistances of the first resistor R1, second resistor R2, and third resistor R3 are not limited in the embodiments of the disclosure.

In the above embodiments, the first divider circuit includes the first resistor, the second resistor and the third resistor. The first terminal of the first resistor is connected to the second voltage divider circuit, the second terminal of the first resistor is grounded, the first terminal of the second resistor is connected to the first terminal of the first resistor, the second terminal of the second resistor is connected to the first terminal of the third resistor, and the second terminal of the third resistor is grounded. The embodiments of the disclosure form two different equivalent resistors in the two cases where the charging device is connected and where the charging device is not connected, thus affecting the voltage division performed by the first voltage divider circuit and the second voltage divider circuit. Because the detection signals are output through hardware connection, the detection signals are not affected by the duty cycle signals, and it is possible to accurately detect whether the charging device is connected to the electric device.

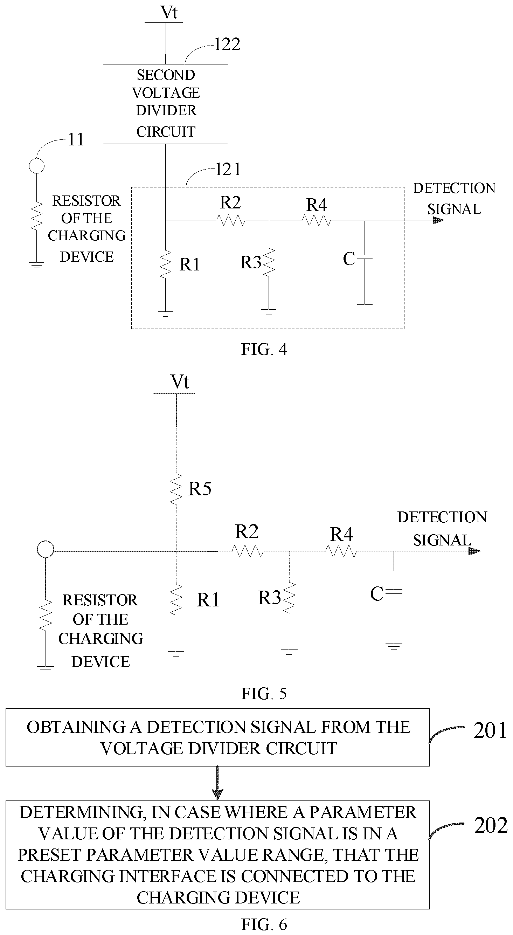

Referring to FIG. 4, according to some embodiments of the disclosure, the first voltage divider circuit 121 also includes a fourth resistor R4 and a capacitor C. A first terminal of the fourth resistor R4 is connected to the second terminal of the second resistor R2, a second terminal of the fourth resistor R4 is connected to a first terminal of the capacitor C, and a second terminal of the capacitor C is grounded.

In the embodiments of the disclosure, the first voltage divider circuit 121 also includes the fourth resistor R4 and the capacitor C. In this case, the first terminal of the fourth resistor R4 is connected with the second terminal of the second resistor R2, the second terminal of the second resistor R2 is connected to the first terminal of the capacitor C, and the second terminal of the capacitor C is grounded.

As shown in FIG. 4, the first terminal of the fourth resistor R4 is connected to the common terminal of the second resistor R2 and the third resistor R3, and the second terminal of the fourth resistor R4 outputs the detection signal. The capacitor C may function as a filter, filtering out an interference signal in the detection signal.

Optionally, the resistance of the fourth resistor R4 may be 33KΩ and the capacitance of the capacitor C may be 473f. The embodiments of the disclosure do not limit the values of the fourth resistor and the capacitor, which may be set according to the actual situation.

In the above embodiments, the first voltage divider circuit also includes the fourth resistor and the capacitor. The first terminal of the fourth resistor is connected to the second terminal of the second resistor, the second terminal of the fourth resistor is connected to the first terminal of the capacitor, and the second terminal of the capacitor is grounded. The embodiments of the disclosure define the detection signal through the fourth resistor, and by filtering out the interference signal in the detection signal with the capacitor, subsequent identification of the detection signal is made more convenient.

Referring to FIG. 5, according to some embodiments of the disclosure, the second voltage divider circuit 122 includes a fifth resistor R5. A first terminal of the fifth resistor R5 is connected to the power supply Vt, and a second terminal of the fifth resistor R5 is connected to the first voltage divider circuit 121.

In embodiments of the disclosure, the second voltage divider circuit 122 also includes the fifth resistor R5, the first terminal of the fifth resistor R5 is connected to the power supply Vt, and the second terminal of the fifth resistor R5 is connected to the first voltage divider circuit 121.

As shown in FIG. 5, the second terminal of the fifth resistor R5 is connected to the first terminal of the first resistor R1 and the first terminal of the second resistor R2. The equivalent resistor formed by the first voltage divider circuit 121 and the fifth resistor R5 perform voltage division of the output voltage of the power supply Vt. In this case, in case where the charging interface 11 is connected to the charging device, the second equivalent resistor formed by the first voltage divider circuit 121 and the fifth resistor R5 are connected in series to perform voltage division of the output voltage of the power supply Vt, and output the first detection signal from the second terminal of the fourth resistor R4. In case where the charging interface 11 is not connected to the charging device, the third equivalent resistor formed by the first voltage divider circuit 121 and the fifth resistor R5 are connected in series, to perform voltage division of the output voltage of the power supply Vt, and output the second detection signal from the second terminal of the fourth resistor R4.

Optionally, the resistance of the fifth resistor R5 may be 1KΩ. The embodiments of the disclosure do not limit the value of the fifth resistor, which may be selected according to the actual situation.

In some embodiments of the disclosure, the fifth resistor R5 may be obtained by connecting multiple resistors in parallel. That is, the second voltage divider circuit 122 is not limited to the description in the above embodiments, and may be set according to the actual situation.

In the above embodiments, the second voltage divider circuit includes the fifth resistor, the first terminal of the fifth resistor is connected to the power supply, and the second terminal of the fifth resistor is connected to the first voltage divider circuit. By performing voltage division of the output voltage of the power supply through the equivalent resistor formed by the fifth resistor and the first voltage divider circuit, the embodiments of the disclosure allow the first voltage divider circuit to output the detection signals. Because the voltage divider circuit outputs the detection signals through hardware connection, the detection signals are not affected by the duty cycle signals, and it is possible to accurately detect whether the charging device is connected with the electric device.

According to some embodiments of the disclosure, an electric device is provided, which includes the charging device interface circuit as in the above embodiments.

In the embodiments of the disclosure, it is possible to arrange the charging device interface circuit described in the above embodiments on the electric device, and the embodiments of the disclosure will not repeat the description of the charging device interface circuit here.

In the two cases where the charging device interface circuit is connected to the charging device and where the charging device interface circuit is not connected to the charging device, the charging device interface circuit may output different detection signals, and the electric device may determine whether to connect the charging device according to the detection signals, so as to take corresponding measures.

In the above embodiments, the electric device includes the charging device interface circuit. Since the charging device interface circuit detects whether the electric device is connected to the charging device through hardware connection, which does not be affected by the duty cycle signals output by the charging pile, and it is possible to detect whether the charging device is connected to the electric device even in case where an abnormal duty cycle signal is output or the duty cycle signal disappears, thus avoiding the problem of pulling the charging device when the electric device starts to drive.

Referring to FIG. 6, according to some embodiments of the disclosure, a charging detection method is provided, which is applicable to any of the charging device interface circuits provided in the embodiments of the disclosure. The charging device interface circuit includes the charging interface and the voltage divider circuit connected to each other. The method may include the following steps:
Step 201, obtaining a detection signal from the voltage divider circuit.

In this case, please refer to the above embodiments for the charging device interface circuit, and the embodiments of the disclosure will not repeat here. The charging device interface circuit outputs a detection signal, and the electric device may obtain the detection signal.

In some embodiments of the disclosure, after the charging device interface circuit outputs the detection signal, it is possible to first perform signal processing of the detection signal, such as analog-to-digital conversion processing, filtering processing, etc., and the processed detection signal is obtained by the electric device.

Step 202, determining, in case where a parameter value of the detection signal is in a preset parameter value range, that the charging interface is connected to the charging device.

The preset parameter value range is stored in the electric device. Compare the parameter value of the detection signal with the preset parameter value range after the detection signal is obtained. Determine that the charging interface is connected to the charging device in case where the parameter value is in the preset parameter value range; and determine that the charging interface is not connected to the charging device in case where the parameter value is not in the preset parameter value range.

For example, the parameter value of the detection signal is aV, and the preset parameter value range is [0, b]. If a is in [0, b], it is determined that the electric device is connected to the charging device. If a is outside [0, b], it is determined that the electric device is not connected to the charging device.

In some embodiments of the disclosure, it is possible to set multiple preset parameter value range since there are multiple models of charging devices. If the parameter value of the detection signal is in any one of the preset parameter value ranges, it is determined that the electric device is connected to the charging device. If the parameter value of the detection signal is outside all preset parameter value ranges, it is determined that the electric device is not connected to the charging device. The embodiments of the disclosure do not limit the preset parameter value range, which may be set according to the actual situation.

It should be noted that the parameter value of the above detection signal may be a voltage value or a current value, which is not limited by the embodiments of the disclosure.

In some embodiments of the disclosure, a Battery Management System (BMS) is provided in the electric device, and it is possible for the BMS to obtain the detection signal and determine whether the electric device is connected to the charging device according to the detection signal. In practice, other module in the electric device may also be used to determine whether the electric device is connected to the charging device, which is not limited by the embodiments of the disclosure.

In some embodiments of the disclosure, during the charging process, the BMS obtains the socket temperature of the charging socket and determines whether to allow the charging device to charge the electric device according to the socket temperature. It should be understood that, by monitoring the temperature of the charging socket through the BMS, it is possible to avoid the charging socket from overheat and damage, thus avoiding damage to the internal components of the electric device, reducing maintenance costs, extending service life, and ensuring the safety of the electric device and the users.

In some embodiments of the disclosure, during the charging process, BMS obtains the status of the electronic lock of the charging socket, and determines whether the charging device falls off according to the status of the electronic lock to avoid people from the danger of electric shock.

In the above embodiments, the detection signal is obtained from the divider circuit of the charging device interface circuit. It is determined that the charging device interface circuit is connected to the charging device in case where the parameter value of the detection signal is in the preset parameter value range. It is determined that the charging interface is not connected to the charging device in case where the parameter value is not in the preset parameter value range. In the embodiments of the disclosure, the charging device interface circuit outputs the detection signal through hardware connection, and detects whether the electric device is connected to the charging device according to the detection signal, which may not be affected by the duty cycle signal output by the charging pile. Therefore, it is also possible to accurately detect whether the charging device is connected to the electric device even in case where an abnormal duty cycle signal is output or the duty cycle signal disappears.

According to some embodiments of the disclosure, it is possible to further include: sending, in case where it is determined that the charging interface is connected to the charging device, a first connection message to a device controller of the electric device, where the first connection message is used to instruct the controller to prohibit the electric device from traveling.

The electric device is provided with the device controller. For example, when the electric device is a vehicle, the device controller may be a Vehicle Control Unit (VCU). The VCU may determine the driver's driving intention by collecting signals such as the accelerator pedal, gear and brake pedal. The VCU monitors the vehicle status information (speed, temperature, etc.), and sends operating status control instructions to the vehicle's power system, power battery system after judging and processing, and at the same time controls the working mode of the vehicle accessories power system. The VCU has system fault diagnosis protection and storage functions.

In case where it is determined that the electric device is connected to the charging device, the BMS may generate the first connection message that the electric device is connected to the charging device, and send the first connection message to the device controller. The device controller receives the first connection message and prohibits the electric device from traveling according to the first connection message. Optionally, the device controller is a VCU, and the VCU limits the motor torque, thus prohibiting the vehicle from travelling.

In some embodiments of the disclosure, during the charging process, the BMS acquires an allowing-charging message sent by the device controller, and cuts off the charging circuit and/or informs the charging pile to stop charging if no allowing-charging message is obtained or a no-charging message is obtained.

In the above embodiments, send, in case where it is determined that the electric device is connected to the charging device, the first connection message to the device controller of the electric device, to instruct the device controller to prohibit the electric device from traveling. By using the device controller to prohibit the electric device from travelling, the embodiments of the disclosure may avoid the problem of pulling the charging device in case where a user starts the electric device but forgets to disconnect the electric device and the charging device after charging.

According to some embodiments of the disclosure, it is possible to further include: sending, in case where it is determined that the charging interface is connected to the charging device, a second connection message to a display og the electric device, where the second connection message is used to instruct the display to display that the electric device is connected to the charging device.

The electric device is provided with the display. For example, the electric device is a vehicle, and the display may be the dashboard, the LCD touch screen, and the like in the vehicle. The embodiments of the disclosure do not limit the display.

In case where it is determined that the electric device is connected to the charging device, the BMS may generate the second connection message that the electric device is connected to the charging device, and send the second connection message to the display. The display receives the second connection message and displays that the electric device is connected to the charging device according to the second connection message.

For example, an indicator light is arranged on the dashboard. After receiving the second connection message sent by the BMS, the dashboard lights up the indicator light. Or, after receiving the second connection message sent by the BMS, the LCD touch screen displays the words or icon "vehicle connected to charging device" on the screen.

In the above embodiments, send, in case where it is determined that the electric device is connected to the charging device, the second connection message to the display in the electric device, to instruct the display to display that the electric device is connected to the charging device. The embodiments of the disclosure may remind the driver that the electric device is connected to the charging device through the display, so as to avoid the problem of pulling the charging device in case where a user starts the electric device but forgets to disconnect the electric device and the charging device.

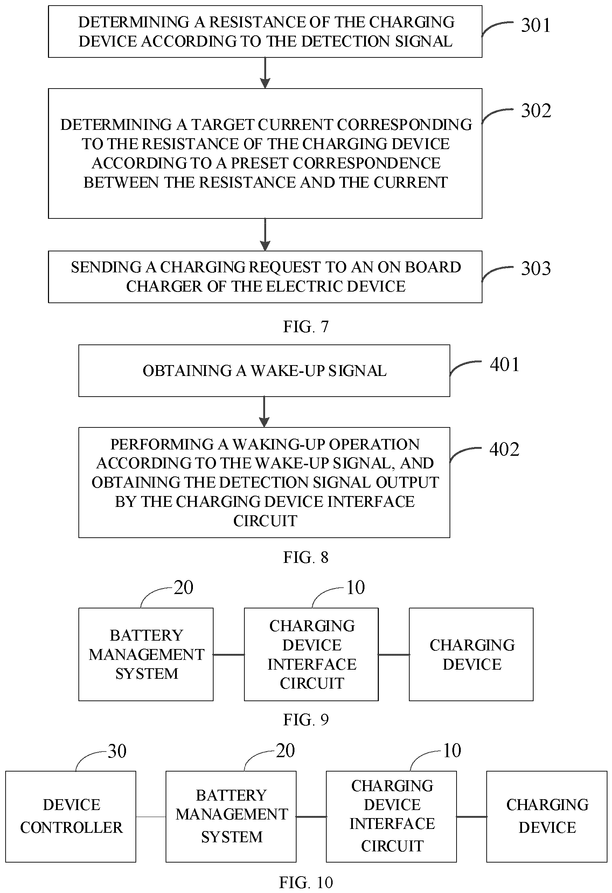

According to some embodiments of the disclosure, as shown in FIG. 7, it is possible to further include the following steps:
Step 301, determining a resistance of the charging device according to the detection signal.

After the detection signal is obtained, it is possible to determine the resistance of the charging device according to a parameter value of the detection signal.

For example, the detection signal is a voltage signal, as shown in FIG. 5, it is possible to determine a second voltage at the common terminal of the second resistor and the third resistor according to a first voltage corresponding to the detection signal and the fourth resistance. It is possible to determine a third voltage at a connection point between the first resistor and the second resistor according to the second voltage, the second resistor and the third resistor. It is possible to determine the equivalent resistor of the first voltage divider circuit according to the fifth resistor, the third voltage and the output voltage of the power supply, and it is possible to determine the resistance of the charging device according to the equivalent resistor, the first resistor, the second resistor and the third resistor.

Step 302, determining a target current corresponding to the resistance of the charging device according to preset mapping between resistance and current values.

The mapping between resistance and current values is preset in the electric device. After the resistance of the charging device is determined, it is possible to determine the target current corresponding to the resistance of the charging device according to the mapping. Table 1 shows the mapping between resistance and current values of a European standard charging device.

**Table 1**

| Resistance | Maximum charging current for on-board charging | Type of connection |
|---|---|---|
| 1500 Ω | unlimited | Configuration FF |
| 680 Ω | 20A | Configuration DD |
| 220 Ω | 32A | Configuration DD |
| 100 Ω | 63A | Configuration DD |

It should be noted that the mapping between the and current values is not limited to a European standard charging device, but also applicable to an American standard charging device, or other charging device, which is not limited in the embodiments of the disclosure.

Step 303, sending a charging request to an on-board charger of the electric device.

In this case, the target current is included in the charging request, for instructing the on-board charger to charge the battery of the electric device according to the target current.

The on-board charger (OBC) is provided in the electric device. The OBC may convert the AC current to the DC current.

After determining the target current corresponding to the resistance of the charging device, the BMS sends the charging request to the on-board charger, and the target current is included in the charging request. The OBC converts the AC current output by the charging pile according to the target current to obtain the DC current, and uses the DC current to charge the battery of the electric device.

In some embodiments of the disclosure, during the charging process, the BMS obtains an OBC parameter and determines whether it is possible to continue the charging according to the OBC parameter, and cuts off the charging circuit and/or informs the charging pile to stop charging if it is determined that the charging cannot be continued according to the OBC parameter. The embodiments of the disclosure do not limit the OBC parameter and the determination method, which may be set according to the actual situation.

In the above embodiments, the resistance of the charging device is determined according to the detection signal. The target current corresponding to the resistance of the charging device is determined according to the preset mapping between resistance and current values. Send the charging request including the target current to the on-board charger of the electric device, and instruct the on-board charger to charge the battery of the electric device according to the target current. The embodiments of the disclosure determines the target current corresponding to the resistance of the charging device, so that the on-board charger may perform current conversion according to the target current, so as to use the appropriate DC current to charge the battery of the electric device, which ensures the charging safety of the electric device.

According to some embodiments of the disclosure, as shown in FIG. 8, it is possible to further include the following steps:

Step 401, obtaining a wake-up signal.

In this case, the wake-up signal includes the wake-up signal sent by a communication controller of the electric device after detecting the duty cycle signal output by the charging pile, and the wake-up signal output by the electric device after the charging of the battery is completed.

The communication controller EVCC may be provided in the electric device. After the electric device is connected to the charging device, the wake-up signal will be output if the EVCC detects the duty cycle signal CP output by the charging pile. The BMS acquires this wake-up signal. In this case, the wake-up signal output by the EVCC may be a 24V/100mA rising edge wake-up signal.

After the charging of the battery is completed, the electric device may also output the wake-up signal, which may wake up the KL15.

In practice, the wake-up signal is not limited to the description in the above embodiments and may also include other wake-up signals.

Step 402, performing a waking-up operation according to the wake-up signal, and obtaining the detection signal output by the charging device interface circuit.

After obtaining the wake-up signal, the BMS performs the waking-up operation, and executes the above steps of obtaining the detection signal output by the charging device interface circuit, then, determines whether the electric device is connected to the charging device according to the obtained detection signal.

In some embodiments of the disclosure, when detecting that the battery is full, the charging pile artificially terminates the charging, or the charging pile abnormally terminates the charging, the BMS sends a third connection message that the electric device is connected to the charging device and a stop-charging request to the EVCC. After receiving the third connection message and the stop-charging request, the EVCC sends an ending-charging instruction to the charging pile and sleeps in a preset time period. The preset time period may be 7s, and the embodiments of the disclosure does not limit the preset time period.

It is understood that EVCC informs the charging pile to end the charging in case where the battery is full, the charging pile artificially terminates the charging, or the charging pile abnormally terminates the charging, which may protect the electric device, and the sleeping EVCC may save power consumption.

In the above embodiments, the wake-up signal is obtained, the waking-up operation is performed according to the wake-up signal, and the detection signal output by the charging device interface circuit is obtained. By using the wake-up signal to wake up the battery management system BMS, the embodiments of the disclosure may ensure that the BMS can timely and accurately detect whether the electric device is connected to the charging device, so as to avoid the problem of pulling the charging device when the electric device starts to drive.

It should be understood that although the steps in the flow chart involved in the embodiments mentioned above are shown sequentially as indicated by the arrows, these steps are not necessarily executed sequentially in the order indicated by the arrows. Unless explicitly stated herein, there is no strict order in which these steps are performed and the steps may be performed in other order. Moreover, at least some of the steps in the flow chart referred to in the embodiments mentioned above may include multiple steps or stages, which are not necessarily completed at the same time, but may be executed at different times, and the order of executing these steps or stages is not necessarily sequential, but may be executed alternately or interchangeably with other steps or with at least part of steps or stages within other steps.

Based on the same invention concept, the embodiments of the disclosure also provide a charging detection device for implementing the aforementioned charging detection method. The implementation solution provided by the device is similar to the implementation solution recited in the above method, so it is possible to refer to the above limitations of the charging detection method for the specific limits of one or more charging detection device embodiments provided below, which will not be repeated here.

Referring to FIG. 9, according to some embodiments of the disclosure, a charging detection system is provided. The charging detection system includes a battery management system 20 and the charging device interface circuit 10 in the above embodiments. The charging device interface circuit 10 is used to output the detection signal. The battery management system 20 is used to obtain the detection signal and determine whether the electric device is connected to the charging device according to the parameter value of the detection signal and the preset parameter value range.

In the embodiments of the disclosure, the charging detection system includes the battery management system 20 and the charging device interface circuit 10. The charging device interface circuit 10 may output different detection signals in the two cases where the charging device is connected and where the charging device is not connected.

The battery management system 20, namely the BMS, may obtain the detection signal output by the charging device interface circuit 10, and then compare the parameter value of the detection signal with the preset parameter value range. It is determined that the electric device is connected to the charging device in case where the parameter value of the detection signal is in the preset parameter value range, and it is determined that the electric device is not connected to the charging device in case where the parameter value of the detection signal is not in the preset parameter value range. The embodiments of the disclosure do not limit the preset parameter value range.

In the above embodiments, the charging detection system includes the battery management system and the charging device interface circuit. The charging device interface circuit outputs the detection signal. The battery management system obtains the detection signal, and determines whether the electric device is connected to the charging device according to the parameter value of the detection signal and the preset parameter value range. In the embodiments of the disclosure, since the charging device interface circuit outputs the detection signal through hardware connection, the battery management system may detect whether the charging device is connected to the electric device without being affected by the duty cycle signal output by the charging pile, so as to avoid the problem of pulling the charging device when the electric device starts to drive.

Referring to FIG. 10, according to some embodiments of the disclosure, the charging detection system also includes a device controller 30. The battery management system 20 sends the first connection message to the device controller 30 when it is determined that the electric device is connected to the charging device. The controller 30 is used for prohibiting the electric device from travelling according to the first connection message.

In the embodiment of the disclosure, the charging detection system also includes the device controller 30, such as the vehicle controller VCU. The battery management system 20 sends the first connection message to the device controller 30 if it is determined that the electric device is connected to the charging device. The device controller receives the first connection message, and prohibits the electric device from travelling according to the first connection message, for example the VCU limits the motor torque.

In the above embodiment, the battery management system sends the first connection message to the device controller in case where it is determined that the electric device is connected to the charging device. The controller prohibits the electric device from traveling according to the first connection message. In this way, even if the user starts to drive because he/she forgets that the electric device is connected to the charging device, the electric device will stay in place because the controller prohibits the electric device from travelling, so the problem of pulling the charging device may be avoided.

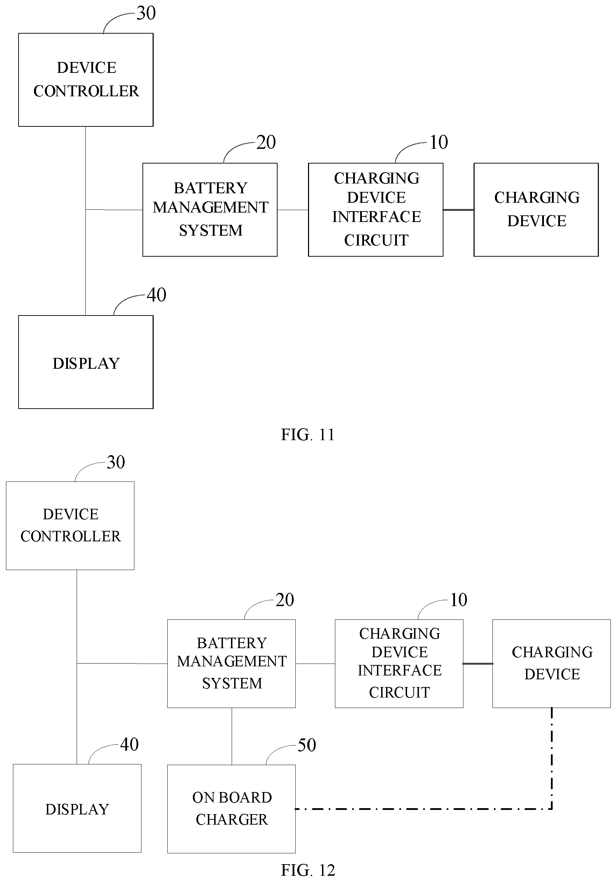

Referring to FIG. 11, according to some embodiments of the disclosure, the charging detection system also includes a display 40. The battery management system 20 is also used for sending the second connection message to the display 40 when it is determined that the electric device is connected to the charging device. The display 40 is used for displaying that the electric device is connected to the charging pile according to the second connection message.

In the embodiments of the disclosure, the charging detection system also includes the display 40, such as the dashboard, the LCD touch screen, etc. The embodiments of the disclosure do not limit the display.

The battery management system 20 sends the second connection message to the display 40 if it is determined that the electric device is connected to the charging device. The display 40 receives the second connection message and displays that the electric device is connected to the charging pile according to the second connection message.

For example, the dashboard is provided with an indicator light. After receiving the second connection message, the dashboard lights up the indicator light to indicate that the electric device is connected to the charging pile. Or, after receiving the second connection message, the LCD touch screen displays the words or icon "connected to the charging pile" on the screen. The embodiments of the disclosure do not limit the display method.

In the above embodiments, the charging detection system also includes the display. The battery management system sends the second connection message to the display in case where it is determined that the electric device is connected to the charging device. The display displays that the electric device is connected to the charging pile according to the second connection message. In this way, the user may be reminded that the electric device is connected to the charging device, so as to avoid the problem that the user starts to drive but forgets that the electric device is connected to the charging device and thus pulls the charging device.

Referring to FIG. 12, according to some embodiments of the disclosure, the charging detection system also includes an on-board charger 50. The battery management system 20 is also used for determining the resistance of the charging device according to the detection signal, and determining the target current corresponding to the resistance of the charging device according to the preset mapping between resistance and current values and the resistance of the charging device, and sending the charging request to the on-board charger 50. The target current is included in the charging request. The on-board charger 50 is used to charge the battery of the electric device according to the target current.

In the embodiments of the disclosure, the charging detection system may also include the on-board charger 50, i.e., the OBC. After obtaining the detection signal, the battery management system 20 determines the resistance of the charging device according to the detection signal. It is possible to refer to the description in the above embodiments for the determination process. The embodiments of the disclosure will not repeat here.

After determining the resistance of the charging device, the BMS determines the target current corresponding to the resistance of the charging device according to the preset mapping between resistance and current values, and then sends the charging request to the OBC.

The OBC receives the charging request, converts the AC current output by the charging pile into the DC current according to the target current in the charging request, and then uses the DC current to charge the battery of the electric device.

In this case, the solid lines in FIG. 12 are the communication cables, and the dashed line is the power transmission cable.

In some embodiments of the disclosure, in case where the charging pile outputs the DC current, it is possible to directly use the DC current output by the charging pile to charge the battery of the electric device.

In the above embodiments, the charging detection system also includes the on-board charger, The battery management system determines the resistance of the charging device according to the detection signal, and determines the target current corresponding to the resistance of the charging device according to the preset mapping between resistance and current values and the resistance of the charging device, and sends the charging request including the target current to the on-board charger. The on-board charger charges the battery of the electric device according to the target current. The embodiments of the disclosure may perform current conversion through the on-board charger, so as to use the appropriate current to charge the battery of the electric device, which ensures the charging safety of the electric device.

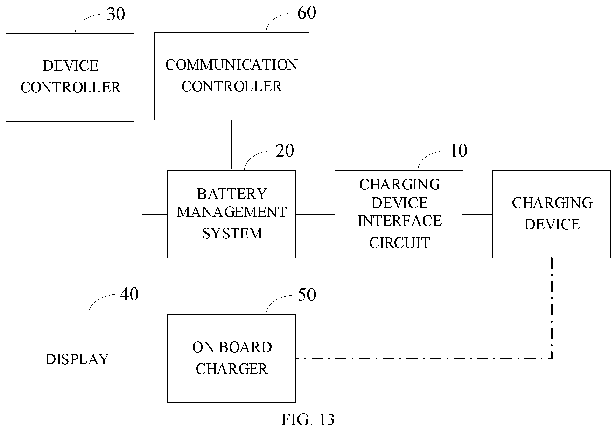

Referring to FIG. 13, according to some embodiments of the disclosure, the charging detection system also includes a communication controller 60. The communication controller 60 is used for sending the wake-up signal to the battery management system 20 after detecting the duty cycle signal output by the charging pile. The battery management system 20 is used for obtaining the wake-up signal, performing the waking-up operation according to the wake-up signal, and obtaining the detection signal output by the charging device interface circuit 10.

In the embodiments of the disclosure, the charging detection system may also include the communication controller 60, such as the EVCC. After the electric device is connected to the charging device, the charging pile outputs the duty cycle signal CP. And after detecting the duty cycle signal CP, the EVCC outputs the wake-up signal. The wake-up signal may be a 24V/100mA rising edge wake-up signal.

The BMS obtains the wake-up signal, then performs the waking-up operation, and obtains the detection signal output by the charging device interface circuit 10, to determine whether the electric device is connected to the charging device according to the detection signal. In case where it is determined that the electric device is connected to the charging device, the BMS sends the first connection message to the VCU, instructing the VCU to prohibit the electric device from travelling, and sends the second connection message to the display 40 to make the display 40 to display that the electric device is connected to the charging device.

The solid lines in FIG 13 are the communication cables, and the dashed line is the power transmission cable.

In the above embodiments, the charging detection system also includes the communication controller. The communication controller sends the wake-up signal to the battery management system after detecting the duty cycle signal output by the charging pile. The battery management system obtains the wake-up signal, performs the waking-up operation according to the wake-up signal, and obtains the detection signal output by the charging device interface circuit. By waking up the battery management system, the embodiments of the disclosure allows the battery management system to timely and accurately detect whether the electric device is connected to the charging device, so as to avoid the problem of pulling the charging device when the electric device starts to drive.

According to some embodiments of the disclosure, a memory is also provided, which includes a storage medium, for example, includes instructions. The above-mentioned instructions may be executed by a processor of the electric device to complete the above-mentioned method. The storage medium may be a non-transitory computer-readable storage medium. For example, the non- transitory computer-readable storage medium may be a ROM, a Random Access Memory (RAM), a CD-ROM, a magnetic tape, a floppy disk, and an optical data storage device, etc.

According to some embodiments of the disclosure, a computer program product is also provided which, when executed by a processor, may implement the above method. The computer program product includes one or more computer instructions. When loading and executing these computer instructions on a computer, some or all of the above methods may be implemented, in whole or in part, in accordance with the processes or functions described in the embodiments of the disclosure.

The technical features of the above embodiments may be combined at will. For the conciseness of description, not all possible combinations of the technical features in the above embodiments have been described. However, as long as there is no contradiction in the combination of these technical features, they shall be considered to be within the scope of this specification.

The above embodiments only present several implementations of the disclosure, for the convenience in understanding the technical solutions of the disclosure specifically and in detail, but cannot therefore be construed as a limitation on the protection scope of the invention patent. It should be noted that it is possible for those skilled in the art to make several modifications and improvements, without deviating from the concept of the disclosure, and these all fall into the protection scope of the disclosure. It should be understood that the technical solutions obtained by those skilled in the art on the basis of the technical solutions provided in the disclosure through logical analysis, reasoning or limited tests are within the protection scope of the claims of the disclosure. Therefore, the protection scope of the disclosure shall be subject to the content of the attached claims, and the specification and the accompanying drawings can be used to explain the content of the claims.

## Claims

1. A charging device interface circuit, comprising a charging interface and a voltage divider circuit connected to each other, wherein the voltage divider circuit is connected with a power supply; and
the voltage divider circuit is used for performing voltage division of an output voltage of the power supply and outputting a detection signal; the detection signal output by the voltage divider circuit in case where the charging interface is connected to a charging device is different from the detection signal output by the voltage divider circuit in case where the charging interface is not connected to a charging device.

2. The charging device interface circuit according to claim 1, wherein the voltage divider circuit comprises a first voltage divider circuit and a second voltage divider circuit; the first voltage divider circuit and the second voltage divider circuit are connected in series, a common terminal of the first voltage divider circuit and the second voltage divider circuit is electrically connected with the charging interface, the second voltage divider circuit is also connected with the power supply; and
the first voltage divider circuit is used for outputting the detection signal.

3. The charging device interface circuit according claim 2, wherein the first voltage divider circuit comprises a first resistor, a second resistor and a third resistor;
a first terminal of the first resistor is connected to the second voltage divider circuit, a second terminal of the first resistor is grounded;
a first terminal of the second resistor is connected to the first terminal of the first resistor, a second terminal of the second resistor is connected to a first terminal of the third resistor; and
a second terminal of the third resistor is grounded.

4. The charging device interface circuit according to claim 3, wherein the first voltage divider circuit further comprises a fourth resistor and a capacitor; and
a first terminal of the fourth resistor is connected to the second terminal of the second resistor, a second terminal of the fourth resistor is connected to a first terminal of the capacitor, and a second terminal of the capacitor is grounded.

5. The charging device interface circuit according to any one of claims 2-4, wherein the second voltage divider circuit comprises a fifth resistor; a first terminal of the fifth resistor is connected to the power supply, and a second terminal of the fifth resistor is connected to the first voltage divider circuit.

6. An electric device comprising the charging device interface circuit according to any one of claims 1-5.

7. A charging detection method applicable to a charging device interface circuit comprising a charging interface and a voltage divider circuit connected to each other, wherein the method comprises:
obtaining a detection signal from the voltage divider circuit; and
determining, in case where a parameter value of the detection signal is in a preset parameter value range, that the charging interface is connected to a charging device.

8. The method according to claim 7, further comprising:
determining, in case where the parameter value is not in the preset parameter value range, that the charging interface is not connected to the charging device.

9. The method according to claim 7, further comprising:
sending, in case where it is determined that the charging interface is connected to the charging device, a first connection message to a device controller of the electric device, wherein the first connection message is used to instruct the controller to prohibit the electric device from traveling.

10. The method according to claim 7, further comprising:
sending, in case where it is determined that the charging interface is connected to the charging device, a second connection message to a display of the electric device, wherein the second connection message is used to instruct the display to display that the electric device is connected to the charging device.

11. The method according to any one of claims 7-10, further comprising:
determining a resistance of the charging device according to the detection signal;
determining a target current corresponding to the resistance of the charging device according to preset mapping between resistance and current values; and
sending a charging request to an on-board charger of the electric device, wherein the target current is included in the charging request, for instructing the on-board charger to charge a battery of the electric device according to the target current.

12. The method according to any one of claims 7-10, further comprising:
obtaining a wake-up signal, wherein the wake-up signal comprises a wake-up signal sent by a communication controller of the electric device after detecting a duty cycle signal output by a charging pile, and a wake-up signal output by the electric device after charging of the battery is completed; and
performing a waking-up operation according to the wake-up signal, and obtaining the detection signal output by the charging device interface circuit.

13. A charging detection system comprising a battery management system and the charging device interface circuit according to any one of claims 1-5, wherein:
the charging device interface circuit is used for outputting the detection signal;
the battery management system is used for obtaining the detection signal and determining whether the electric device is connected to the charging device according to a parameter value of the detection signal and a preset parameter value range.

14. The charging detection system according to claim 13, further comprising a device controller, wherein:
the battery management system sends a first connection message to the device controller in case where it is determined that the electric device is connected to the charging device; and
the device controller is used for prohibiting the electric device from travelling according to the first connection message.

15. The charging detection system according to claim 14, further comprising a display, wherein:
the battery management system is also used for sending a second connection message to the display in case where it is determined that the electric device is connected to the charging device; and
the display is used for displaying that the electric device is connected to the charging pile according to the second connection message.

16. The charging detection system according to any one of claims 13-15, further comprising an on-board charger, wherein:
the battery management system is also used for determining a resistance of the charging device according to the detection signal, and determining a target current corresponding to the resistance of the charging device according to preset mapping between resistance and current values and the resistance of the charging device, and sending a charging request to the on-board charger, the target current included in the charging request; and
the on-board charger is used for charging a battery of the electric device according to the target current.

17. The charging detection system according to any one of claims 13-15, further comprising a communication controller, wherein:
the communication controller is used for sending a wake-up signal to the battery management system after detecting a duty cycle signal output by a charging pile; and
the battery management system is used for obtaining the wake-up signal, performing a waking-up operation according to the wake-up signal, and obtaining the detection signal output by the charging device interface circuit.

18. A computer-readable storage medium having stored thereon a computer program, which, when executed by a processor, implements steps of the method according to any one of claims 7-12.

19. A computer program product comprising a computer program, which, when executed by a processor, implements steps of the method according to any one of claims 7-12.
